# EUROPEAN PATENT APPLICATION

(11) **EP 4 651 193 A1**
(43) Date of publication of application: **19.11.2025**
(21) Application number: 24176291.3
(22) Date of filing: 16.05.2024
(51) Int. Cl.: H01L 21/683, H01L 21/687

(54) **CARRIER, ASSESSMENT APPARATUS, AND METHOD OF USING THE CARRIER**

(71) Applicant: ASML Netherlands B.V., 5500 AH Veldhoven (NL)
(72) Inventor: TATEO, Flaviano, Veldhoven (NL); LI, Yinglong, Veldhoven (NL)
(74) Representative: ASML Netherlands B.V.

(57) **Abstract**

The present invention provides a carrier comprising a carrier surface. The carrier surface is configured to face a first major surface of a sample. A second major surface of the sample, opposite the first major surface of the sample, is configured to contact a sample support. The carrier surface comprises a gripping device configured to contact the sample, and to lift the sample away from the sample support.

## Description

### FIELD

The embodiments provided herein generally relate to a carrier, an assessment apparatus comprising the carrier, and a method of using the carrier.

### BACKGROUND

When manufacturing semiconductor integrated circuit (IC) chips, undesired pattern defects, as a consequence of, for example, optical effects and incidental particles, inevitably occur on a substrate (i.e. wafer or sample) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

The sample may be held in place during inspection by a sample support. The sample support typically comprises a clamp to secure the sample to the sample support. In some cases, the clamp is an electrostatic clamp. In some circumstances, the sample may not be completely released from the clamp on completion of the inspection. For example, with an electrostatic clamp, there may be a buildup of charge, which can have the effect of retaining the sample in place on the sample support.

In the circumstances where a sample is not released, an operator may be required to halt the machine. The machine may remain off while the system is returned to ambient, as opposed to vacuum, conditions such that the machine can be opened for the operator to manually retrieve the sample which has been unintentionally retained by the clamp. This manual sample extraction procedure leads to a significant amount of downtime for the machine. Furthermore, the procedure has a relatively high risk of causing contamination or damage to the system as well as damage to the sample. Damage or contamination of the system can lead to further downtime for decontamination and/or repairs.

There is therefore a desire to provide a more efficient and less disruptive means to remove a sample unintentionally retained on the sample support after inspection.

### SUMMARY

It is an object of the present disclosure to provide embodiments of a carrier, an assessment apparatus comprising the carrier, and a method of using the carrier.

According to an aspect of the invention, there is provided a carrier comprising a carrier surface. The carrier surface is configured to face a first major surface of a sample. A second major surface of the sample, opposite the first major surface of the sample, is configured to contact a sample support. The carrier surface comprises a gripping device configured to contact the sample, and to lift the sample away from the sample support.

According to another aspect of the invention, there is provided an assessment apparatus for inspecting a sample. The assessment apparatus comprises the carrier.

According to another aspect of the invention, there is provided a method of removing a sample from a sample support using the carrier.

### BRIEF DESCRIPTION OF FIGURES

The above and other aspects of the present disclosure will become more apparent from the description of exemplary embodiments, taken in conjunction with the accompanying drawings.
**FIG.** 1 is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram illustrating a carrier for lifting a sample off a sample support.
**FIG. 4** is a schematic diagram illustrating gripping mechanisms and separators of a carrier.
**FIG. 5** is a schematic diagram illustrating the carrier of **FIG. 4** from below.
**FIG. 6** is a schematic diagram illustrating a cross-sectional view through a carrier, depicting a gripping mechanism and a plurality of separators.
**FIG. 7** is a schematic diagram illustrating the feet of the gripping mechanism of the carrier of **FIG. 3****.**

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer or sample) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

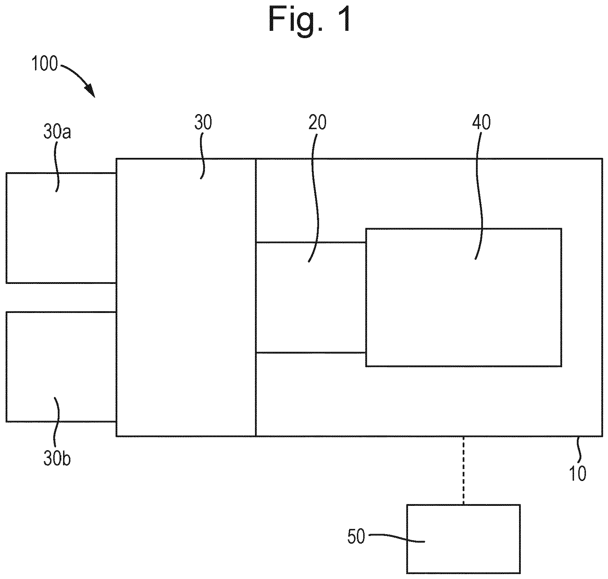

Reference is now made to **FIG. 1**, which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

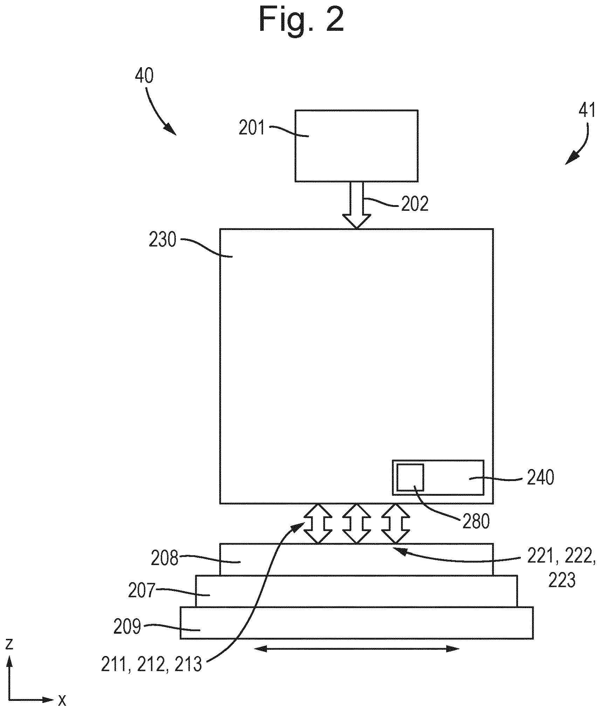

Reference is now made to **FIG. 2**, which is a schematic diagram illustrating an exemplary charged particle assessment system 40 including a multi-beam charged particle device 41 that is part of the exemplary charged particle beam assessment apparatus 100 of **FIG. 1**. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The multi-beam charged particle device 41 of **FIG. 2** comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1**, such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2**, in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

The sample may be held in place during inspection by a sample support. The sample support may be a sample holder 207, such as that shown in FIG. 2. The sample support 207 typically comprises a clamp to secure the sample 208 to the sample support. In some cases, the clamp is an electrostatic clamp. In some circumstances, the sample may not be completely released from the clamp on completion of the inspection. For example, with an electrostatic clamp, there may be a buildup of charge, which can have the effect of retaining the sample 208 in place on the sample support 207.

In the circumstances where a sample 208 is not released, an operator may be required to halt the machine (otherwise referred to as the assessment system, or the inspection apparatus). The machine may remain off while the system is returned from vacuum conditions to ambient conditions such that the machine can be opened for the operator to manually retrieve the sample 208 which has been unintentionally retained by the clamp. This manual sample extraction procedure leads to a significant amount of downtime for the machine. Furthermore, the procedure has a relatively high risk of causing contamination or damage to the system as well as damage to the sample. Damage or contamination of the system can lead to further downtime for decontamination and/or repairs. The entire procedure may take as much as three days, requiring extended downtime of the machine.

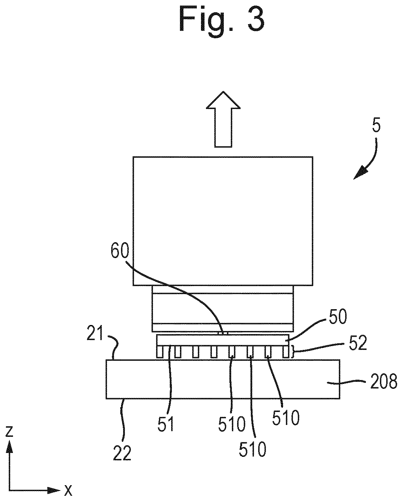

There is therefore a desire to provide a more efficient and less disruptive means to remove a sample unintentionally retained on the sample support after inspection. This may be achieved by providing a carrier 5, for example, as illustrated in **FIG. 3. FIG. 3** shows the carrier 5 and a substrate or sample 208. The carrier 5 is configured to remove the sample 208 from the sample support 207. The carrier 5 may desirably enable the sample to be removed from the sample support in between less than a minute and a few minutes. Thus, the downtime of the machine is significantly reduced compared to a manual procedure which could amount to multiple days of downtime.

The sample 208 has a first major surface 21 and a second major surface, opposite the first major surface 22. In particular, the sample 208 may be substantially disc shaped, with the first and second major surfaces being the opposing flat sides of the disc. The second major surface of the sample 208, opposite the first major surface of the sample, is configured to contact a sample support 207. For example, the sample 208 may be arranged on a sample support 207 as described above with respect to **FIG. 2**. Furthermore, the carrier 5 may be configured such that, during use, the carrier 5 may be disposed between the projection apparatus 230 and the sample 208. An assessment system, such as that of **FIG. 2**, may comprise the carrier 5.

The carrier 5 comprises a carrier surface 51. The carrier surface 51 may be a surface of a carrier plate 50. During use, the carrier 5 may be disposed such that the carrier surface 51 faces the first major surface 21 of the sample 208. For example, during inspection the carrier 5 is desirably disposed at a position outside the beam path. If needed to remove an unintentionally retained sample 208, the carrier 5 may be moved such that the carrier surface 51 is aligned with the sample 208.

The carrier surface 51 comprises a gripping device 52 configured to contact the sample 208. During use, the carrier surface 51 is desirably disposed such that the gripping device 52 is aligned with the sample 208. The carrier 5 is configured to lift the sample 208 away from the sample support 207. In particular, the carrier 5 may lift the sample 208 while the gripping device 52 is in contact with the sample 208 to secure the sample 208 to the carrier 5.

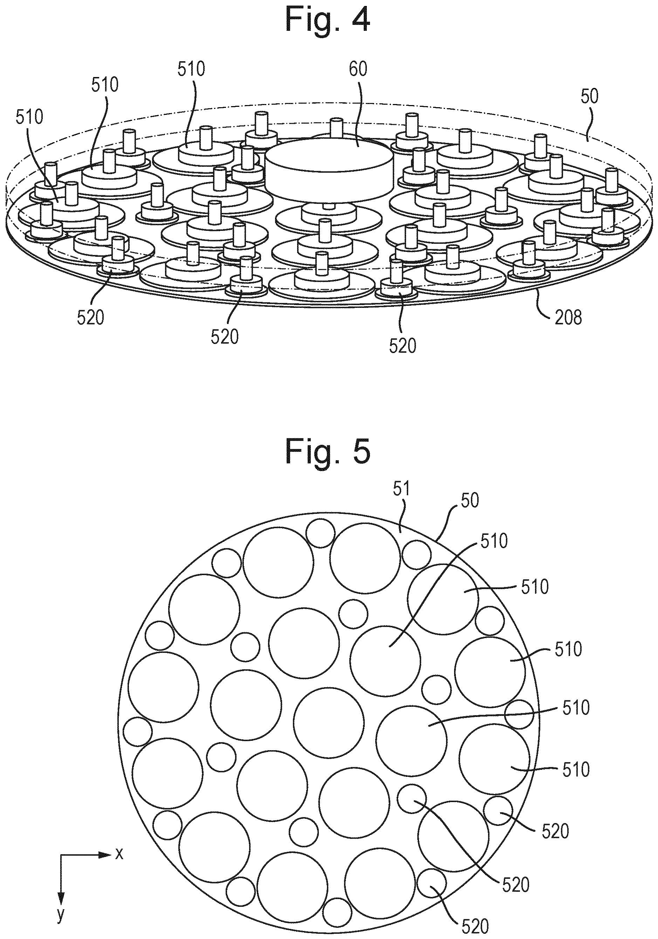

All or part of the carrier 5 may be configured to move in a direction (Z-direction of **FIG. 4**) away from the sample support 207 in order to lift the sample 208 away from the sample support. For example, the gripping device 52 may be configured to retract away from the sample support 207 to lift the sample 208 away from the sample support 207. Alternatively, or additionally, the entire carrier 5 may be configured to move away from the sample support 207 to lift the sample 208 away from the sample support 207. Optionally, the carrier 5 may be configured to move out of a location of the beam path, for example after the sample 208 has been lifted away such that it is no longer retained by the sample support 207.

The gripping device 52 is desirably configured to apply a gripping force to the sample 208. In particular, the gripping force is desirably sufficient to overcome any force undesirably retaining the sample 208 to the sample support 207. The sample support 207 may comprises a clamp configured to secure the second surface 22 of the sample 208 to the sample support 207. The clamp may be an electrostatic clamp. The gripping force is desirably sufficient to overcome a build up of charge on the electrostatic clamp which may otherwise undesirably retain the sample 208. In other words, the gripping force should enable the sample 208 to be lifted away from the sample support 207, without the gripping device losing grip or dropping the sample 208. In this way, the unintentionally retained sample 208 may be readily removed from the assessment apparatus without direct manual intervention by an operator. This may save a significant amount of time and reduce the risk of damage and contamination to the apparatus and the sample.

The gripping device 52 is desirably configured to apply the gripping force at least in a direction orthogonal to a plane of the first major surface 21 of the sample 208 (i.e., at least in the Z-direction of **FIG. 3**). The gripping device may be configured to adhere to the first major surface 21 of the sample 208. In other words, the gripping device may contact and apply the gripping force directly to the first major surface 21 of the sample 208.

In a preferred arrangement, the gripping device 52 is configured to controllably apply the gripping force to the sample 208. The gripping device 52 is desirably configured to be activated to apply the gripping force. For example, the gripping device 52 may be configured such that the gripping force is activated in response to receiving a control input. Alternatively, or additionally, the gripping device 52 may be configured to be activated in response to detecting that the gripping device is in contact with the sample 208. The gripping device 52 may also be configured to be de-activated to release the gripping force.

The gripping force is desirably controllable in magnitude. For example, the gripping device 52 may be configured to receive a control input to apply a target gripping force. The target gripping force may be predetermined. In this way, the sample 208 may be held securely without risk of damage by excessive gripping loads. Additionally, or alternatively, the gripping force may optionally be controllable in direction.

The carrier 5 optionally further comprises one or more load cells 60. In the arrangements of **FIG. 3** and **FIG. 4**, the load cell 60 is disposed on the carrier plate 50. In this arrangement, the load cell 60 is disposed on an opposite side of the carrier plate 50 than the carrier surface 51. The one or more load cells 60 are configured to measure a force exerted on the sample 208 by the carrier 5 and/or a force exerted on the sample 208 by the sample support 207. The carrier 5 may be configured such that the gripping force is controllable based on measurements from the one or more load cells.

The gripping device 52 desirably comprises one or more gripping mechanisms 510. The gripping mechanisms 510 may be the part of the gripping device 52 which is configured to apply the gripping force to the sample 208.

The gripping mechanism 510 may comprise a piezo-actuator. The gripping mechanism 510 may be mechanically activated by an electronic signal. For example, the gripping mechanism 510 may comprise a piezo-actuated component, such as a piezo-actuated rod or arm configured to be activated to grip the sample 208.

In a preferred arrangement the gripping mechanism 510 comprise a gecko pad. In other words, the gripping mechanism 510 may be configured to act as a dry adhesive, which may passively grip the sample 208, without requiring activation to provide an adhesive effect. Furthermore, the gripping mechanism 510 may comprise synthetic setae.

The use of a piezo-actuated component in combination with gecko pad is desirable because this arrangement may enable a sufficient gripping force to be applied in a controllable manner and with a relatively low risk of damage to the sample 208.

The piezo-actuated gripping mechanism 510 may be activated via a piezo stack. In particular, the piezo stack may be arranged to provide motion in a direction orthogonal to the carrier surface 51 (Z-direction in **FIG. 3**). This direction is desirably also orthogonal to the first major surface 21 of the sample 208. In this way, a gripping force may be applied to aid in lifting the sample 208 in the direction orthogonal to the first major surface 21 of the sample 208 and away from the sample support 207.

The carrier plate 50 is desirably electrically conductive. In particular, the carrier plate 50 is desirably configured such that the gripping mechanism 510 can be piezo-actuated via the carrier plate 50. For example, the carrier plate 50 may at least comprise metal. The carrier plate 50 desirably consists of metal. In an arrangement, such as that of **FIG. 4** and **FIG. 5**, a plurality of gripping mechanisms 510 may be provided on the carrier surface 51 of the carrier plate 50. The electrically conductive carrier plate 50 may desirably enable the plurality of gripping mechanisms to be controlled collectively in an efficient and effective manner. In particular, the plurality of gripping mechanisms may be collectively activated and deactivated. In this way, the sample 208 may avoid undergoing uneven force distribution with might otherwise be caused if some gripping mechanisms activate before others.

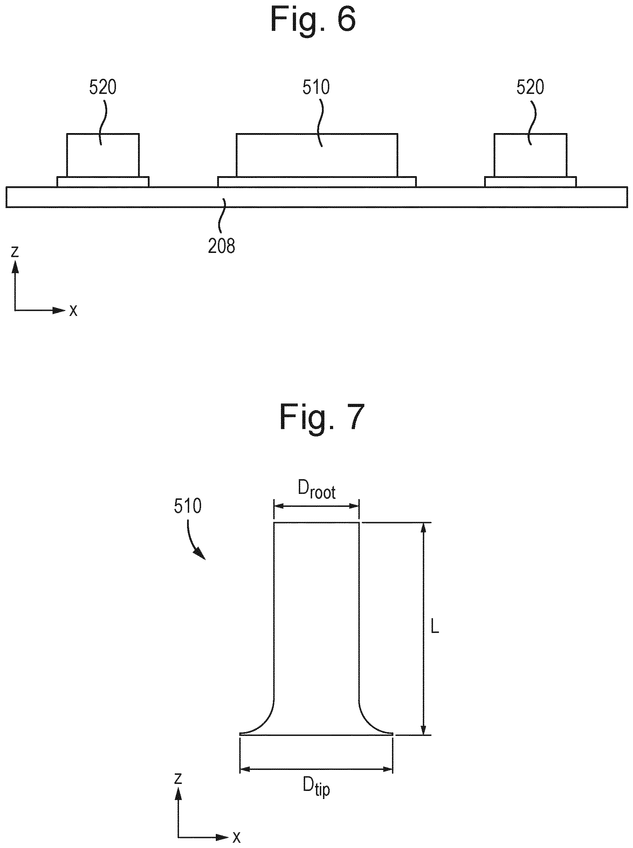

**FIG. 7** is a schematic diagram illustrating the feet of the gripping mechanism of the carrier of **FIG. 3****.** In particular, **FIG. 7** provides a side view of a possible profile of a piezo-actuated gripping mechanism 510. A tip of the piezo-actuated gripping mechanism 510 is configured to contact the sample 208. In a preferred arrangement, a gecko-pad may be provided on the tip of the piezo-actuated gripping mechanism 510. A root of the piezo-actuated gripping mechanism 510 is configured to be farthest from the sample 208 during use, and may be in contact with the carrier plate 50. A width Dtip of the piezo-actuated gripping mechanism 510 at the tip may be greater than a width Droot of the piezo-actuated gripping mechanism 510 at the root. In this way, an surface area of the piezo-actuated gripping mechanism at the tip may be greater than a surface area at the root. The greater surface area configured to contact the sample 208, the more evenly the gripping force applied by the piezo-actuated gripping mechanism 510 may be applied to the sample 208.

In another arrangement (not shown in the figures), the gripping device may comprise a gripping claw as the gripping mechanism. For example, the gripping mechanism may be configured to grip a peripheral surface of the sample 208 with a plurality of gripping arms.

In an alternative arrangement, the gripping device may comprise a suction-based device. The suction-based device may comprise one or more suction cups as gripping mechanisms. The one or more suction cups may be suction cups. The one or more suction cups may be passive. In other words, the suction cups may apply a gripping force on contact with the sample 208 without requiring any activation. Alternatively, the suction cups may be configured to be activated.

In another arrangement, the suction-based device is configured to be activated to apply the gripping force to the sample, and to be de-activated to release the gripping force. The suction-based device optionally comprises a suction-mechanism defining a plurality of channels. The plurality of channels may be defined such that a negative pressure may be provided through the channels to grip the sample 208 to the suction-based device using suction. This arrangement may beneficially enable control of the magnitude of the gripping force.

In each of the arrangements of **FIGs. 3 to 5**, the gripping device comprises a plurality of gripping mechanisms 510. **FIG. 4** is a schematic diagram illustrating a carrier 5 comprising carrier plate 50 with a plurality of gripping mechanisms 510 attached to the carrier surface of the carrier plate 50. **FIG. 5** is a schematic diagram illustrating the carrier of **FIG. 4** from below. In the arrangements of **FIGs. 3 to 5**, the gripping mechanisms 510 comprise piezo-actuated components with gecko pads. In an alternative arrangement, some or all of the gecko pad gripping mechanisms of the arrangements of **FIGs. 3 to 5** may be replaced by an alternative type of gripping mechanism. Any suitable means of gripping the sample 208 for lifting the sample 208 away from the sample support 207 may be used. For example, suction cups may be used as the gripping mechanisms 510, optionally in combination with piez-actuated rods/arms.

All of the gripping mechanisms 510 may be configured to apply the gripping force with a predetermined global magnitude. Additionally, or alternatively, each individual gripping mechanism 510 of the plurality of gripping mechanisms may be configured to apply the gripping force with a predetermined individual magnitude. The predetermined individual magnitude may be the same for all of the gripping mechanisms 510. Alternatively, the predetermined individual magnitude may differ between gripping mechanisms 510. For example, it may be that gripping mechanisms 510 configured to grip the sample 208 nearer a periphery of the sample may have a greater or smaller predetermined individual magnitude than gripping mechanisms 510 configured to grip the sample 208 nearer a center of the sample 208.

The plurality of gripping mechanisms 510 is desirably configured to be collectively controllable. In other words, the plurality of gripping mechanisms 510 may be configured to be activated and/or de-activated collectively, based on a global control input. In this way, all of the gripping mechanisms 510 may readily be able to apply the gripping force to the sample 208 simultaneously. Similarly, a magnitude and/or direction of the gripping force to be applied may be collectively controllable.

Additionally, or alternatively, each of the plurality of gripping mechanisms 510 may be configured to be individually controllable. In other words, each of the plurality of gripping mechanisms 510 may be configured to be activated and/or de-activated individually, based on a plurality of individual control inputs. Furthermore, the plurality of gripping mechanisms 510 may be grouped into sub-sets, each sub-set having one or more gripping mechanisms 510. Each sub-set of gripping mechanism 510 may be controllable such that the gripping mechanisms 510 within the same sub-set are collectively controllable, and each sub-set is controllable independently of the other subsets. For example, a sub-set of gripping mechanisms 510 may be activated to grip a sample having a smaller diameter than a span covered by the plurality of gripping mechanisms 510.

The gripping mechanisms 510 are desirably distributed across the carrier surface 51. In particular, it is desirable that the gripping mechanisms are arranged such that the gripping mechanisms 510 will be distributed across the sample 208. For example, a number and spacing of gripping mechanisms 510 may be determined as appropriate to the corresponding sample 208. In this way, the gripping force may be relatively evenly distributed across the sample 208. This may reduce a likelihood of damaging the sample 208 while gripping and lifting the sample 208.

In the arrangement of **FIGs. 4 and 5**, the gripping mechanisms 510 are arranged in an array on the carrier surface 51. The array in **FIGs. 4 and 5** is a circular array. In alternative arrangements, the array may be a hexagonal array or an orthogonal array.

As shown, for example, in **FIGs. 4 and 5**, the carrier 5 may further comprise a separator device configured to release the sample 208 from the carrier 5. The separator device comprises one or more separator mechanisms 520 configured to contact the sample 208 to aid in releasing the sample 208 from the carrier 5. In particular, the separator mechanisms 520 may be configured to apply a separating force to release the sample 208 from the carrier 5. For example, the separator mechanisms 520 may push the sample 208 away from the carrier surface 51. The separator mechanisms 520 are preferably activated when the carrier 5 is located away from the sample holder 207, such that the sample 208 is deposited in a location away from the sample holder 207. In this way, the likelihood of the sample 208 becoming stuck to the carrier 5 is reduced. This may be beneficial as otherwise, more time and effort may be taken to remove the sample 208 from the carrier 5.

In the arrangement of **FIGs. 4 and 5**, there are a plurality of separator mechanisms 520. The separator mechanisms of **FIG 4 and 5** are distributed across the carrier surface 51.

**FIG. 6** is a schematic diagram illustrating a cross-sectional view through a carrier 5, such as that of **FIGs. 4 and 5****.** In particular, **FIG. 6** depicts a gripping mechanism 510 and a plurality of separators 520 (alternatively referred to as separators). As shown in **FIG. 6**, the gripping mechanism 510 is configured to apply a gripping force to the sample 208 in a direction (positive Z direction in **FIG. 6**) to attract the sample 208 towards the gripping mechanism 510, which is desirably also a direction towards the carrier surface 51. The gripping mechanisms 510 may contract towards, or into, the carrier plate 50 to apply the gripping force. The separator mechanisms 520 are configured to apply a separating force to the sample 208 in a direction (negative Z direction in **FIG. 6**) to repel the sample 208 away from the separator mechanisms 520, which is desirably also a direction away from the carrier surface 51. The separator mechanisms 520 may extend away from the carrier plate 50 to apply the separating force.

The separator device desirably comprises a piezo-actuator. For example, each of the one or more separator mechanisms 520 may comprise, or consist of, a piezo-actuator. In an arrangement such as that of **FIGs. 4 and 5**, wherein the separator device and the gripping device both comprise piezo-actuators, reversed polarity voltage may activates both the separator device and the gripping device. In particular, one polarity of voltage may activate the gripping device, such that the gripping mechanisms 510 grip the sample 208, with the separator mechanisms 520 deactivated. A reverse polarity of voltage may activate the separator device, such that the separator mechanisms 520 help to release the sample 208 from the carrier 5, with the gripping mechanisms 510 deactivated., for example once the sample 208 has been removed. In this way, the gripping device and the separator device may both be operated in a simple, efficient, and cost-effective manner.

Similarly to the gripping mechanisms 510, as described above, the plurality of separator mechanisms 520 may be configured to be collectively controllable. In other words, all of the separator mechanisms 520, or one or more sub-sets of separator mechanisms 520, may be configured to be controlled to activate and/or de-activate based on a global control command. Alternatively, or additionally, each of the plurality of separator mechanisms is configured to be individually controllable.

The separator mechanisms 520 are desirably distributed across the carrier surface 51. In particular, it is desirable that the separator mechanisms are arranged such that the separator mechanisms 520 will be distributed across the sample 208. For example, a number and spacing of separator mechanisms 520 may be determined as appropriate to the corresponding sample 208. In this way, the separating force may be relatively evenly distributed across the sample 208. This may reduce a likelihood of damaging the sample 208 while releasing the sample 208.

In the arrangement of **FIGs. 4 and 5**, the separator mechanisms 520 are arranged in an array on the carrier surface 51. The array in **FIGs. 4 and 5** is a circular array. In alternative arrangements, the array may be a hexagonal array or an orthogonal array.

The separator mechanisms 520 may be evenly distributed among the gripping mechanisms 510. For example, there may be a separator mechanism 520 between adjacent gripping mechanisms 510.

If a sample 208 has become unintentionally retained by the sample holder 207, the carrier 5 may be moved to position in alignment with the sample 208. For example, an external mechanism, which may form part of the assessment apparatus, may be configured to move the carrier 5. For example, the carrier 5 may be moved in a plane (X-Y plane of **FIGs. 3 to 6**) parallel to plant of the first major surface 21 of the sample 208. In this way, the carrier 5 is desirably positioned such that the gripping device 52 is aligned with the sample 208 (i.e., directly above the sample 208 in a Z-direction of **FIGs. 3 to 6**). In this position, the carrier surface 51 faces the first major surface 21 of the sample 208.

The gripping device 52, desirably one or more gripping mechanisms 510, may then make contact with the sample 208 and apply the gripping force to the sample 208, for example by activating the gripping mechanisms 510. The carrier 5 may then lift the sample 208 away from the sample support 207. Lifting the sample away from the sample support may be done by lifting all or part of the carrier 5 in a direction (Z direction of FIGs. 3 to 6) away from the sample support 207. For example, the gripping device 52 or the gripping mechanism 510 may be lifted in a direction (Z direction of **FIGs. 3 to 6**) away from the sample support 207. The carrier 5 may be moved to a position out of alignment with the sample holder 207. For example, the carrier may be moved in a plane (X-Y plane of FIGs. 3 to 6) parallel to plant of the first major surface 21 of the sample 208, until the sample 208 is entirely clear of the sample holder 207. In particular, the carrier 5 is desirably moved to a position out of the beam path.

The sample 208 may then be released from the carrier 5, for example by deactivating the gripping mechanisms 510. If the carrier 5 comprises a separator device, the separating force may be applied by the separator mechanisms 520 in order to help release the sample 208 from the carrier 5. The released sample 208 may then be removed from the machine.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one sub-device may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

Embodiments include the following numbered clauses:
1. A carrier comprising
   a carrier surface configured to face a first major surface of a sample,
   wherein a second major surface of the sample, opposite the first major surface of the sample, is configured to contact a sample support,
   wherein the carrier surface comprises a gripping device configured to contact the sample, and to lift the sample away from the sample support.
2. The carrier according to clause 1, wherein the sample support comprises a clamp configured to secure the second surface of the sample to the sample support.
3. The carrier according to clause 2, wherein the clamp is an electrostatic clamp.
4. The carrier according to any preceding clause, wherein the gripping device is configured to apply a gripping force to the sample.
5. The carrier according to clause 4, wherein the gripping device is configured to apply the gripping force in a direction orthogonal to a plane of the first major surface of the sample.
6. The carrier according to clause 5, wherein the gripping device is configured to adhere to the first major surface of the sample.
7. The carrier according to any of clauses 4 to 6, wherein the gripping device is configured to controllably apply the gripping force to the sample.
8. The carrier according to clause 7, wherein the gripping force is controllable in magnitude.
9. The carrier according to either of clauses 7 and 8, wherein the gripping force is controllable in direction.
10. The carrier according to any of clauses 4 to 9, wherein the gripping device is configured to be activated to apply the gripping force.
11. The carrier according to clause 10, wherein the gripping device is configured to be deactivated to release the gripping force.
12. The carrier according to any of clauses 4 to 11, wherein the gripping device comprises one or more gripping mechanisms, wherein the gripping mechanisms are configured to apply the gripping force to the sample.
13. The carrier according to clause 12, wherein the gripping device comprises a plurality of gripping mechanisms.
14. The carrier according to clause 13, wherein the plurality of gripping mechanisms is configured to be collectively controllable.
15. The carrier according to either of clauses 13 and 14, wherein each of the plurality of gripping mechanisms is configured to be individually controllable.
16. The carrier according to any of clauses 14 to 15, wherein gripping mechanisms are arranged in an array on the carrier surface.
17. The carrier according to any one of clauses 13 to 16, wherein the gripping mechanisms are evenly distributed across the carrier surface.
18. The carrier according to any of clauses 12 to 17, wherein the gripping mechanism is configured to apply the gripping force with a predetermined magnitude.
19. The carrier according to any of clauses 12 to 18, wherein the gripping mechanism comprises a piezo-actuator.
20. The carrier according to any one of clauses 12 to 19, wherein the gripping mechanism comprises a gecko pad.
21. The carrier according to any preceding clause, wherein the carrier comprises a carrier plate, the carrier surface is a surface of the carrier plate, and the carrier plate comprises metal.
22. The carrier according to clause 21, wherein the carrier plate consists of metal.
23. The carrier according to any of clauses 12 to 18, wherein the gripping mechanism comprises a gripping claw.
24. The carrier according to any of clauses 12 to 18, wherein the gripping mechanism comprises a suction-based mechanism.
25. The carrier according to clause 24, wherein the suction-based mechanism is a passive suction cup.
26. The carrier according to clause 24, wherein the suction-based mechanism is a suction mechanism configured to be activated to apply the gripping force to the sample, and to be de-activated to release the gripping force.
27. The carrier according to any preceding clause, wherein the carrier comprises a separator device configured to release the sample from the carrier.
28. The carrier according to clause 27, wherein the separator device comprises a piezo-actuator.
29. The carrier according to clause 28, when dependent on any one of clauses 19 to 22, wherein a reversed polarity voltage activates both the separator device and the gripping device.
30. The carrier according to any of clauses 27 to 29, wherein the separator device comprises one or more separator mechanisms, wherein the separator mechanisms are configured to apply a separating force to release the sample.
31. The carrier according to clause 30, wherein the separator device comprises a plurality of separator mechanisms.
32. The carrier according to clause 31, wherein the plurality of separator mechanisms is configured to be collectively controllable.
33. The carrier according to either of clauses 31 and 32, wherein each of the plurality of separator mechanisms is configured to be individually controllable.
34. The carrier according to any of clauses 31 to 33, wherein separator mechanisms are arranged in an array on the carrier surface.
35. The carrier according to any of clauses 16, 17 and 34, wherein the array is a circular array, a hexagonal array, or an orthogonal array.
36. The carrier according to any of clauses 30 to 35, wherein the separator mechanisms are evenly distributed across the carrier surface.
37. The carrier according to any of clauses 31 to 36, when dependent on any of clauses 13 to 17, wherein the separator mechanisms are evenly distributed among the gripping mechanisms.
38. The carrier of any of the preceding clauses, further comprising a load cell configured to measure a force exerted on the sample by the carrier and/or the sample support.
39. An assessment apparatus for inspecting a sample, the assessment apparatus comprising a carrier according to any of the preceding clauses.
40. The assessment apparatus of clause 39, comprising:
   a sample support configured to support the sample.
41. The assessment apparatus according to either of clauses 39 and 40, wherein the sample support comprises a clamp configured to secure the second surface of the sample to the sample support.
42. The assessment apparatus according to clause 41, wherein the clamp is an electrostatic clamp.
43. A method of removing a sample from a sample support using the carrier of any one of clauses 1 to 38.
44. The method of clause 43, comprising
   arranging the carrier at a location such that the carrier surface faces the first major surface of the sample,
   contacting the sample with the gripping mechanism, and
   lifting the sample away from the sample support using the carrier.
45. The method of clause 44, wherein lifting the sample away from the sample support comprises, lifting the carrier and/or lifting the gripping mechanism.
46. The method of either of clauses 44 and 45, wherein arranging the carrier at the location comprises aligning the carrier surface with the sample.

## Claims

1. A carrier comprising
a carrier surface configured to face a first major surface of a sample,
wherein a second major surface of the sample, opposite the first major surface of the sample, is configured to contact a sample support,
wherein the carrier surface comprises a gripping device configured to contact the sample, and to lift the sample away from the sample support.

2. The carrier according to any preceding claim, wherein the gripping device is configured to apply a gripping force to the sample.

3. The carrier according to claim 2, wherein the gripping device is configured to apply the gripping force in a direction orthogonal to a plane of the first major surface of the sample.

4. The carrier according to claim 3, wherein the gripping device is configured to adhere to the first major surface of the sample.

5. The carrier according to any of claims 2 to 4, wherein the gripping device is configured to controllably apply the gripping force to the sample.

6. The carrier according to any of claims 2 to 5, wherein the gripping device is configured to be activated to apply the gripping force.

7. The carrier according to any of claims 2 to 6, wherein the gripping device comprises one or more gripping mechanisms, wherein the gripping mechanisms are configured to apply the gripping force to the sample.

8. The carrier according to claim 7, wherein the gripping device comprises a plurality of gripping mechanisms.

9. The carrier according to claim 8, wherein the plurality of gripping mechanisms is configured to be collectively controllable.

10. The carrier according to any one of claims 7 to 9, wherein the gripping mechanism comprises a gecko pad.

11. The carrier according to any preceding claim, wherein the carrier comprises a separator device configured to release the sample from the carrier.

12. The carrier of any of the preceding claims, further comprising a load cell configured to measure a force exerted on the sample by the carrier and/or the sample support.

13. An assessment apparatus for inspecting a sample, the assessment apparatus comprising a carrier according to any of the preceding claims.

14. The assessment apparatus of claim 13, comprising:
a sample support configured to support the sample.

15. A method of removing a sample from a sample support using the carrier of any one of claims 1 to 12, comprising
arranging the carrier at a location such that the carrier surface faces the first major surface of the sample,
contacting the sample with the gripping mechanism, and
lifting the sample away from the sample support using the carrier.
